# EUROPÄISCHE PATENTSCHRIFT

(11) **EP 2 233 519 B1**
(45) Veröffentlichungstag und Bekanntmachung des Hinweises auf die Patenterteilung: **31.08.2011**
(21) Anmeldenummer: 09156428.6
(22) Anmeldetag: 27.03.2009
(51) Int. Cl.: C08K 3/22, C08K 3/32, C08K 5/02, C08K 13/00

(54) **Glühdrahtbeständige Polyester**
Glow wire resistant polyester
Polyester résistant au test du fil incandescent

(43) Veröffentlichungstag der Anmeldung: 29.09.2010
(73) Patentinhaber: LANXESS Deutschland GmbH, 51369 Leverkusen (DE)
(72) Erfinder: Schäfer, Marcus Dr., 47803 Krefeld (DE); Endtner, Jochen Dr., 50679 Köln (DE); Bienmüller, Matthias Dr., 47803 Krefeld (DE); Jantz, Ralf, 53757 St. Augustin (DE); Radeck, Alexander, Pok Fu Lam Hong Kong (CN)

(56) Entgegenhaltungen:
- EP-A- 1 274 288
- EP-A- 1 288 260
- EP-A- 1 992 662

## Beschreibung

Die Erfindung betrifft glühdrahtbeständige Polyesterformmassen enthaltend Kupferchromit und wenigstens ein Antimon-haltiges Funktionsadditiv in Kombination mit wenigstens einer monomeren, oligomeren oder polymeren organischen Verbindung, die einfach oder mehrfach bromierte Phenylgruppen enthält, sowie die Verwendung dieser Polyesterformmassen zur Herstellung glühdrahtbeständiger Laser-Direkt-strukturierbarer Bauteile, bevorzugt Haushaltsgeräte.

Da spritzgegossene Schaltungsträger häufig im Bereich der Industrie-, Unterhaltungs- oder Hausgeräteelektronik eingesetzt werden, müssen auch die Normen und Vorgaben aus diesen Bereichen berücksichtigt werden. In der Hausgeräteelektronik werden beispielsweise Vorgaben aus der IEC/EN 60335-1 zur Wärme- und Feuerbeständigkeit der Produkte beschrieben. So gilt für nichtmetallische Werkstoffe, die stromführende Verbindungen in ihrer Lage halten, unter anderem die Vorgabe, Glühdrahtprüfungen durchzuführen. Je nach Einsatzgebiet und Stromstärke der Anwendungen, müssen Glühdrahtprüfungen bei 550 °C bis 850 °C durchgeführt werden. Zu diesen Anwendungen zählen beispielsweise Kippschalter, Drehschalter, Regler, Verbindungselemente, Steckverbinder, Gehäuse, Kontaktkammern, Relais, Widerstände, Kondensatoren, Schütze, induktive Bauelemente, Transformatoren, Transistoren, Sensoren und vieles mehr. In der Industrieelektronik werden Glühdrahtprüfungen bis 960 °C durchgeführt.

DE 10 2004 003 891 A1 lehrt den Einsatz des kupferhaltigen Spinells CuCr₂O₄ (Kupferchromit) in Polyestern in Kombination mit organischen Bromverbindungen zur Herstellung orientierter, mittels elektromagnetischer Strahlung strukturierbarer Folien.

DE 10 2004 039 148 A1 beschreibt verstärkte glühdrahtbeständige flammwidrige Polymere, die 40 bis 90 Gew.-% Polymer, bevorzugt Polyamide enthalten. Ebenso beschreibt DE 10 2004 048 876 A1 thermoplastische Formmassen auf Basis von Polyamid mit erhöhter Glühdrahtbeständigkeit.

Für die Anwendung in Haushaltsgeräten ist in Deutschland jedoch künftig die Einhaltung der Glühdrahtnorm nach IEC 60695-2-12 und -13 zwingend vorgeschrieben. Insbesondere für den so genannten GWIT (glow wire ignition temperature) stehen zuwenig polymere Materialien zur Verfügung, die eine Entzündungstemperatur von über 750°C erreichen.

Es war daher Aufgabe der vorliegenden Erfindung, glühdrahtbeständige Polyester zur Verfügung zu stellen, die die im Elektro- und Elektronikbereich geforderten Brandnormen erfüllen, gut zu verarbeiten sind, ausreichende mechanische Werte aufweisen und als fertige Bauteile dem LDS-Verfahren unterzogen werden können.

Lösung der Aufgabe und Gegenstand der vorliegenden Erfindung sind glühdrahtbeständige Polyesterformmassen enthaltend Kupferchromit (CuCr₂O₄) und wenigstens ein Antimon-haltiges Funktionsadditiv der Reihe Natriumantimonat, Antimontrioxid oder Antimonpentoxid in Kombination mit wenigstens einer organischen Bromverbindung der Reihe N,N-Ethylenbis(tetrabromphthalimid), epoxidiertes Tetrabrombisphenol A-Harz, Tetrabrombispshenol-A-oligocarbonat, Pentabrompolyacrylat, Polypentabrombenzylacrylat, bromiertes Polystyrol, Decabromdiphenylether oder Decabromdiphenylethan.

Eine Anwendungsinformation zur IEC/EN 60695-2-12 und -13 findet sich im Internet unter http://techcenter.lanxess.com/scp/emea/de/media/TI%202006-011%20DE%20Erweiterte%20Haushaltsger%C3%A4tenorm%20IEC%2060335.pdf?docId=109962 und ist als Ausgabe TI 2006-011DE, Ausgabe 10.07.2006 von der Lanxess Deutschland GmbH erhältlich.

Danach wird der GWIT (Glow Wire Ignition Temperature = IEC 60695-2-13) an einer Prüfplatte (Rundscheibe) gemessen und ist ein Maß für die Entzündung eines Kunststoffes bei Einwirkung beispielsweise eines glühenden Drahtes oder eines überhitzten Widerstandes. Bei der Bestimmung der Zündtemperatur darf sich der Probenkörper während der gesamten Prüfung nicht entzünden. Entzündung ist definiert als Branderscheinung größer 5 Sekunden. Als GWIT wird dann die Temperatur angegeben, die 25 °C höher ist, als die höchste Temperatur, bei der noch keine Entzündung stattfindet. Der GWIT wird für flammgeschützte Materialien vom Hersteller angegeben und ist auf der Yellow Card der Underwriter Laboratories (UL)gelistet. Seit 2005 wurde von UL eine Änderung verbindlich eingeführt: Wenn der GWIT für kleine Wandstärken höher ist, als für dickere Wandstärken, so wird dieser für die Yellow Card nicht gewertet, sondern es zählt der niedrigere Wert.

Daneben wird der GWFI (Glow Wire Flammability Index = IEC 60695-2-12) ebenfalls an der Prüfplatte (Rundscheibe) gemessen und ist ein Maß für das Flammverhalten von Kunststoffen gegenüber der Einwirkung beispielsweise eines glühenden Drahtes oder eines überhitzten Widerstandes. Der Probekörper wird 30 Sekunden lang mit einer Kraft von 1 Newton gegen einen aufgeheizten Glühdraht gepresst. Die Eindringtiefe des Glühdrahts ist auf 7 mm begrenzt. Der Test ist bestanden, wenn der Probekörper nach Entfernen des Glühdrahtes weniger als 30 Sekunden nachbrennt und wenn sich ein unter dem Probekörper liegendes Seidenpapier nicht entzündet. Der GWFI wird für flammgeschützte Materialien vom Hersteller angegeben und ist auf der Yellow Card gelistet.

Außerdem sei an dieser Stelle noch auf Plastverarbeiter 56, Jahrg. (2005) Nr. 4, 66-67 verwiesen.

Bevorzugte Antimon-haltige Funktionsadditive sind Antimontrioxid oder Natriumantimonat.

Bevorzugte organische Bromverbindungen sind Tetrabrombisphenol-A-epoxyoligomer, Tetrabrombisphenol-A-oligocarbonat, Polypentabrombenzylacrylat oder N-N'-Ethylen-bis(tetrabromphthalimid).

Unter den Tetrabrombisphenol-A-epoxyoligomeren werden besonders bevorzugt solche mit Epoxy-Endgruppen oder Tribromphenylengruppen eingesetzt. Unter den Tetrabrombisphenol-A-oligocarbonaten werden besonders bevorzugt solche mit Phenyl-, Tribromphenyl- oder p-Ditertbutylphenyl-Endgruppen eingesetzt. Unter den bromierten Polystyrolen werden besonders bevorzugt solche mit 2 bis 3 Brom-Atomen pro Phenylring eingesetzt. Typische kommerzielle Beispiele für erfindungsgemäß einzusetzende organische Bromverbindungen sind Eurobrom F3100, Eurobrom F2400 und Eurobrom FR1025 der Firma Fa. ICL IP (Beer Sheva, Israel), ferner PBS64, PDBS 80, BC52 und BC58 der Firma Chemtura (Middlebury, USA), außerdem Saytex HP7010,Saytex HP3010, Saytex BR93, Saytex 8010 und Saytex BT93 der Firma Albemarle (Baton Rouge, USA).

Erfindungsgemäß besonders bevorzugt sind glühdrahtbeständige Polyesterformmassen enthaltend Kupferchromit, Antimontrioxid sowie eine organische Bromverbindung der Reihe Tetrabrombisphenol-A-epoxyoligomer, Tetrabrombisphenol-A-oligocarbonat, Polypentabrombenzylacrylat oder N-N'-Ethylen-bis(tetrabromphthalimid).

Erfindungsgemäß besonders bevorzugt sind aber auch glühdrahtbeständige Polyesterformmassen enthaltend Kupferchromit, Natriumantimonat sowie eine organische Bromverbindung der Reihe Tetrabrombisphenol-A-epoxyoligomer, Tetrabrombisphenol-A-oligocarbonat, Polypentabrombenzylacrylat oder N-N'-Ethylen-bis(tetrabromphthalimid).

Insbesondere bevorzugt sind glühdratbeständige Polyesterformmassen enthaltend Kupferchromit, Natriumantimonat und Tetrabrombisphenol-A-epoxyoligomer.

Insbesondere bevorzugt sind aber auch glühdratbeständige Polyesterformmassen enthaltend Kupferchromit, Natriumantimonat und Tetrabrombisphenol-A-oligocarbonat.

Insbesondere bevorzugt sind aber auch glühdratbeständige Polyesterformmassen enthaltend Kupferchromit, Natriumantimonat und Polypentabrombenzylacrylat.

Insbesondere bevorzugt sind aber auch glühdratbeständige Polyesterformmassen enthaltend Kupferchromit, Natriumantimonat und N,N'-Ethylen-bis(tetrabromphthalimid).

Insbesondere bevorzugt sind aber auch glühdratbeständige Polyesterformmassen enthaltend Kupferchromit, Antimontrioxid und Tetrabrombisphenol-A-oligocarbonat.

Insbesondere bevorzugt sind aber auch glühdratbeständige Polyesterfommassen enthaltend Kupferchromit, Antimontrioxid und Polypentabrombenzylacrylat.

Insbesondere bevorzugt sind aber auch glühdratbeständige Pulyesterformmassen enthaltend Kupferchromit, Antimontrioxid und N,N'-Ethylenbis(tetrabromphthalimid).

Die vorliegende Erfindung betrifft bevorzugt glühdrahtbeständige Polyesterformmassen, dadurch gekennzeichnet, dass sie
als Komponente A 40 bis 90 Gew.-% Polyester,
als Komponente B 0,1 bis 40 Gew.-% Kupferchromit,
als Komponente C 0,1 bis 15 Gew.-% Antimon-haltiges Funktionsadditiv und
als Komponente D 0,1 bis 20 Gew.-% organische Bromverbindung
enthalten.

Bevorzugt ist die Komponente A in Mengen von 45 bis 65 Gew.-% in den glühdrahtbeständigen Polyesterformmassen enthalten.

Besonders bevorzugt ist die Komponente A in Mengen von 50 bis 65 Gew.-% in den glühdrahtbeständigen Polyesterformmassen enthalten.

Bevorzugt ist die Komponente B in Mengen von 0,5 bis 20 Gew.-% in den glühdrahtbeständigen Polyesterformmassen enthalten.

Insbesondere bevorzugt ist die Komponente B in Mengen von 1 bis 10 Gew.-% in den glühdrahtbeständigen Polyesterformmassen enthalten.

Besonders bevorzugt ist die Komponente C in Mengen von 0,5 bis 10 Gew.-% in den glühdrahtbeständigen Polyesterformmassen enthalten.

Insbesondere bevorzugt ist die Komponente C in Mengen von 1 bis 8 Gew.-% in den glühdrahtbeständigen Polyesterformmassen enthalten.

Besonders bevorzugt ist die Komponente D in Mengen von 0,5 bis 18 Gew.-% in den glühdrahtbeständigen Polyesterformmassen enthalten.

Insbesondere bevorzugt ist die Komponente D in Mengen von 1 bis 15 Gew.-% in den glühdrahtbeständigen Polyesterformmassen enthalten.

Erfindungsgemäß bevorzugte Polyester sind die Polyalkylenterephthalate.

Polyalkylenterephthalate im Sinne der Erfindung sind Reaktionsprodukte aus aromatischen Dicarbonsäuren oder ihren reaktionsfähigen Derivaten, bevorzugt Dimethylestern oder Anhydriden, und aliphatischen, cycloaliphatischen oder araliphatischen Diolen und Mischungen dieser Reaktionsprodukte.

Bevorzugte Polyalkylenterephthalate lassen sich aus Terephthalsäure (oder ihren reaktionsfähigen Derivaten) und aliphatischen oder cycloaliphatischen Diolen mit 2 bis 10 C-Atomen nach bekannten Methoden herstellen (Kunststoff-Handbuch, Bd. VIII, S. 695 FF, Karl-Hanser-Verlag, München 1973).

Bevorzugte Polyalkylenterephthalate enthalten mindestens 80 Mol-%, vorzugsweise 90 Mol-%, bezogen auf die Dicarbonsäure, Terephthalsäurereste und mindestens 80 Mol-%, vorzugsweise mindestens 90 Mol-%, bezogen auf die Diolkomponente, Ethylenglykol- und/oder Propandiol-1,3-und/oder Butandiol-1,4-reste.

Die bevorzugten Polyalkylenterephthalate können neben Terephthalsäureresten bis zu 20 Mol-% Reste anderer aromatischer Dicarbonsäuren mit 8 bis 14 C-Atomen oder Reste aliphatischer Dicarbonsäuren mit 4 bis 12 C-Atomen enthalten, wie Reste von Phthalsäure, Isophthalsäure, Naphthalin-2,6-dicarbonsäure, 4,4'-Diphenyldicarbonsäure, Bernstein-, Adipin-, Sebacinsäure, Azelainsäure, Cyclohexandiessigsäure, Cyclohexandicarbonsäure.

Die bevorzugten Polyalkylenterephthalate können neben Ethylen- bzw. Propandiol-1,3- bzw. Butandiol-1,4-glykolresten bis zu 20 Mol-% anderer aliphatischer Diole mit 3 bis 12 C-Atomen oder cycloaliphatischer Diole mit 6 bis 21 C-Atomen enthalten, z.B. Reste von Propandiol-1,3, 2-Ethylpropandiol-1,3, Neopentylglykol, Pentan-diol-1,5, Hexandiol-1.6, Cyclohexan-dimethanol-1,4, 3-Methylpentandiol-2,4, 2-Methylpentandiol-2,4, 2,2,4-Trimethylpentandiol-1,3 und -1,6,2-Ethyl-hexandiol-1,3 2,2-Diethylpropandiol-1,3, Hexandiol-2,5, 1,4-Di-(β-hydroxyethoxy)-benzol, 2,2-Bis-(4-hydroxycyclohexyl)-propan, 2,4-Dihydroxy-1,1,3,3-tetramethyl-cyclobutan, 2,2-bis-(3-β-hydroxyethoxyphenyl)-propan und 2,2-bis-(4-hydroxypropoxyphenyl)-propan (DE-A 24 07 674 (= US 4 035 958), DE-A 24 07 776, DE-A 27 15 932 (=US 4 176 224)).

Die Polyalkylenterephthalate können durch Einbau relativ kleiner Mengen 3- oder 4-wertiger Alkohole oder 3- oder 4-basischer Carbonsäuren, wie sie z.B. in der DE-A 19 00 270 (= US-A 3 692 744) beschrieben sind, verzweigt werden. Beispiele für bevorzugte Verzweigungsmittel sind Trimesinsäure, Trimellitsäure, Trimethylolethan und -propan und Pentaerythrit.

Es ist ratsam, nicht mehr als 1 Mol-% des Verzweigungsmittels, bezogen auf die Säurekomponente, zu verwenden.

Besonders bevorzugt sind Polyalkylenterephthalate, die aus Terephthalsäure und deren reaktionsfähigen Derivaten (z.B. deren Dialkylestern) und Ethylenglykol und/oder Propandiol-1,3 und/oder Butandiol-1,4 hergestellt werden und Mischungen dieser Polyalkylenterephthalate.

Bevorzugte Polyalkylenterephthalate sind auch Copolyester, die aus mindestens zwei der obengenannten Säurekomponenten und/oder aus mindestens zwei der obengenannten Alkoholkomponenten hergestellt werden, besonders bevorzugte Copolyester sind Poly-(ethylenglykol/butandiol-1,4)-terephthalate.

Insbesondere bevorzugte Polyalkylenterephthalate sind Polyethylenterephthalat oder Polybutylenterephthalat oder Mischungen dieser beiden Polyalkylenterephthalate.

Die erfindungsgemäß einzusetzenden Polyalkylenterephthalate besitzen bevorzugt eine intrinsische Viskosität von ca. 0,3 cm³/g bis 1,5 cm³/g, besonders bevorzugt 0,4 cm³/g bis 1,3 cm³/g, insbesonders bevorzugt 0,5 cm³/g bis 1,0 cm³/g jeweils gemessen in Phenol/o-Dichlorbenzol (1:1 Gew.-Teile) bei 25°C.

Die Polyester können auch im Gemisch mit anderen Polyestern und/oder weiteren Polymeren eingesetzt werden.

In einer bevorzugten Ausführungsform können den erfindungsgemäßen glühdrahtbeständigen Polyesterformmassen zusätzlich wenigstens ein Additiv der Reihe Füll- und Verstärkungsstoffe, Elastomermodifikatoren, Stabilisatoren, anorganische Pigmente, Gleit- und Entformungsmittel und/oder Fließhilfsmittel sowie weitere übliche Additive in der Schmelze zugemischt oder auf der Oberfläche aufgebracht werden.

Erfindungsgemäß bevorzugt einzusetzende Füll- und/oder Verstärkungsstoffe sind Stoffe der Reihe Talk, Glimmer, Silikat, Quarz, Titandioxid, Wollastonit, Kaolin, amorphe Kieselsäuren, Magnesiumcarbonat, Kreide, Feldspat, Bariumsulfat, Glaskugeln und/oder faserförmige Füllstoffe und/oder Verstärkungsstoffen auf der Basis von Kohlenstofffasern und/oder Glasfasern. Besonders bevorzugt werden mineralische teilchenförmige Füllstoffe der Reihe Talk, Glimmer, Silikat, Quarz, Titandioxid, Wollastonit, Kaolin, amorphe Kieselsäuren, Magnesiumcarbonat, Kreide, Feldspat, Bariumsulfat und/oder Glasfasern eingesetzt. Ganz besonders bevorzugt werden erfindungsgemäß mineralische teilchenförmige Füllstoffe auf der Basis von Talk, Wollastonit, Kaolin und/oder Glasfasern eingesetzt.

Insbesonders bevorzugt werden ferner auch nadelförmige mineralische Füllstoffe eingesetzt. Unter nadelförmigen mineralischen Füllstoffen wird erfindungsgemäß ein mineralischer Füllstoff mit stark ausgeprägtem nadelförmigen Charakter verstanden. Als Beispiel seien nadelförmige Wollastonite genannt. Bevorzugt weist das Mineral ein Länge : Durchmesser - Verhältnis von 2:1 bis 35:1, besonders bevorzugt von 3:1 bis 19:1, am meisten bevorzugt von 4:1 bis 12:1 auf. Die mittlere Teilchengröße der erfindungsgemäßen nadelförmigen Mineralien liegt bevorzugt bei kleiner 20 µm, besonders bevorzugt bei kleiner 15 µm, insbesondere bevorzugt bei kleiner 10 µm bestimmt mit einem CILAS GRANULOMETER.

Der Füllstoff und/oder Verstärkungsstoff kann in einer bevorzugten Ausführungsform oberflächenmodifiziert sein, bevorzugt mit einem Haftvermittler bzw. Haftvermittlersystem auf Silanbasis. Die Vorbehandlung ist jedoch nicht unbedingt erforderlich. Insbesondere bei Verwendung von Glasfasern können zusätzlich zu Silanen auch Polymerdispersionen, Filmbildner, Verzweiger und/oder Glasfaserverarbeitungshilfsmittel verwendet werden.

Die erfindungsgemäß besonders bevorzugt einzusetzenden Glasfasern, die im allgemeinen einen Faserdurchmesser zwischen 7 und 18 µm, bevorzugt zwischen 9 und 15 µm haben, werden als Endlosfasern oder als geschnittene oder gemahlene Glasfasern zugesetzt. Die Fasern können mit einem geeigneten Schlichtesystem und einem Haftvermittler bzw. Haftvermittlersystem, bevorzugt auf Silanbasis, ausgerüstet sein.

Gebräuchliche Haftvermittler auf Silanbasis für die Vorbehandlung sind Silanverbindungen der allgemeinen Formel (III)

(X-(CH₂)_{q})k-Si-(O-CrH₂r+1)₄-k (III)

in der die Substituenten folgende Bedeutung haben:
X: NH₂-, HO-, 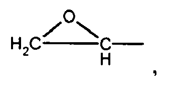 q: eine ganze Zahl von 2 bis 10, bevorzugt 3 bis 4,
r: eine ganze Zahl von 1 bis 5, bevorzugt 1 bis 2,
k: eine ganze Zahl von 1 bis 3, bevorzugt 1.

Bevorzugte Haftvermittler sind Silanverbindungen aus der Gruppe Aminopropyltrimethoxysilan, Aminobutyltrimethoxysilan, Aminopropyltriethoxysilan, Aminobutyltriethoxysilan sowie die entsprechenden Silane, welche als Substituent X eine Glycidylgruppe enthalten.

Für die Ausrüstung der Füllstoffe werden die Silanverbindungen im Allgemeinen in Mengen von 0,05 bis 2 Gew.-%, vorzugsweise 0,25 bis 1,5 Gew.-% und insbesondere 0,5 bis 1 Gew.-% bezogen auf den mineralischen Füllstoff zur Oberflächenbeschichtung eingesetzt.

Die teilchenförmigen Füllstoffe können bedingt durch die Verarbeitung zur Formmasse bzw. Formkörper in der Formmasse bzw. im Formkörper einen kleineren d97- bzw. d50-Wert aufweisen, als die ursprünglich eingesetzten Füllstoffe. Die Glasfasern können bedingt durch die Verarbeitung zur Formmasse bzw. Formkörper in der Formmasse bzw. im Formkörper kürzere Längenverteilungen als ursprünglich eingesetzt aufweisen.

Erfindungsgemäß kann aber auch eine Mischung aus zwei oder mehreren unterschiedlichen Füllstoffen eingesetzt werden.

In einer bevorzugten Ausführungsform können die erfindungsgemäßen thermoplastischen Formmassen neben dem teilkristallinen Thermoplasten und dem erfindungsgemäßen Stoffgemisch und zusätzlich zum Füllstoff oder anstelle des Füllstoffes 0,001 bis 80 Gew.-Teile, bevorzugt 2 bis 40 Gew.-Teile, besonders bevorzugt 4 bis 19 Gew.-Teile mindestens eines Elastomermodifikators enthalten.

Die einzusetzenden Elastomermodifikatoren umfassen ein oder mehrere Pfropfpolymerisate von
- E.1: 5 bis 95 Gew.-%, vorzugsweise 30 bis 90 Gew.-%, wenigstens eines Vinylmonomeren auf
- E.2: 95 bis 5 Gew.-%, vorzugsweise 70 bis 10 Gew.-% einer oder mehrerer Pfropfgrundlagen mit Glasübergangstemperaturen < 10°C, vorzugsweise < 0°C, besonders bevorzugt < -20°C.

Die Pfropfgrundlage E.2 hat im Allgemeinen eine mittlere Teilchengröße (d50-Wert) von 0,05 bis 10 µm, vorzugsweise 0,1 bis 5 µm, besonders bevorzugt 0,2 bis 1 µm.

Monomere E.1 sind vorzugsweise Gemische aus
- E.1.1: 50 bis 99 Gew.-% Vinylaromaten und/oder kernsubstituierten Vinylaromaten (wie beispiels- weise Styrol, α-Methylstyrol, p-Methylstyrol, p-Chlorstyrol) und/oder Methacrylsäure-(C1- C8)-Alkylester (wie z.B. Methylmethacrylat, Ethylmethacrylat) und
- E.1.2: 1 bis 50 Gew.-% Vinylcyanide (ungesättigte Nitrile wie Acrylnitril und Methacrylnitril) und/oder (Meth)Acrylsäure-(C1-C8)-Alkylester (wie z.B. Methylmethacrylat, n-Butyl- acrylat, t-Butylacrylat) und/oder Derivate (wie Anhydride und Imide) ungesättigter Carbon- säuren (beispielsweise Maleinsäureanhydrid und N-Phenyl-Maleinimid).

Bevorzugte Monomere E.1.1 sind ausgewählt aus mindestens einem der Monomere Styrol, α-Methylstyrol und Methylmethacrylat, bevorzugte Monomere E.1.2 sind ausgewählt aus mindestens einem der Monomere Acrylnitril, Maleinsäureanhydrid und Methylmethacrylat.

Besonders bevorzugte Monomere sind E.1.1 Styrol und E.1.2 Acrylnitril.

Für die in den Elastomermodifikatoren einzusetztenden Pfropfpolymerisate geeignete Pfropfgrundlagen E.2 sind beispielsweise Dienkautschuke, EP(D)M-Kautschuke, also solche auf Basis Ethylen/Propylen und gegebenenfalls Dien, Acrylat-, Polyurethan-, Silikon-, Chloropren und Ethylen/Vinylacetat-Kautschuke.

Bevorzugte Pfropfgrundlagen E.2 sind Dienkautschuke (z.B. auf Basis Butadien, Isopren etc.) oder Gemische von Dienkautschuken oder Copolymerisate von Dienkautschuken oder deren Gemischen mit weiteren copolymerisierbaren Monomeren (z.B. gemäß E.1.1 und E.1.2), mit der Maßgabe, dass die Glasübergangstemperatur der Komponente E.2 unterhalb <10°C, vorzugsweise <0°C, besonders bevorzugt <-10°C liegt.

Besonders bevorzugt ist als Pfropfgrundlage E.2. reiner Polybutadienkautschuk.

Besonders bevorzugte als Elastomermodifikatoren einsetzbare Polymerisate sind ABS-Polymerisate (Emulsions-, Masse- und Suspensions-ABS), wie sie z. B. in der DE-A 2 035 390 (=US-A 3 644 574) oder in der DE-A 2 248 242 (=GB-A 1 409 275) bzw. in Ullmann, Enzyklopädie der Technischen Chemie, Bd. 19 (1980), S. 280 ff. beschrieben sind. Der Gelanteil der Pfropfgrundlage E.2 beträgt mindestens 30 Gew.-%, vorzugsweise mindestens 40 Gew.-% (in Toluol gemessen).

Die Elastomermodifikatoren bzw. Pfropfcopolymerisate werden durch radikalische Polymerisation, z.B. durch Emulsions-, Suspensions-, Lösungs- oder Massepolymerisation, vorzugsweise durch Emulsions- oder Massepolymerisation hergestellt.

Besonders geeignete Pfropfkautschuke sind auch ABS-Polymerisate, die durch Redox-Initiierung mit einem Initiatorsystem aus organischem Hydroperoxid und Ascorbinsäure gemäß US-A 4 937 285 hergestellt werden.

Da bei der Pfropfreaktion die Pfropfmonomeren bekanntlich nicht unbedingt vollständig auf die Pfropfgrundlage aufgepfropft werden, werden erfindungsgemäß unter als Pfropfpolymerisaten einsetzbare Elastomermodifikatoren auch solche Produkte verstanden, die durch (Co)Polymerisation der Pfropfmonomere in Gegenwart der Pfropfgrundlage gewonnen werden und bei der Aufarbeitung mit anfallen.

Geeignete Acrylatkautschuke basieren auf Propfgrundlagen E.2, die vorzugsweise Polymerisate aus Acrylsäurealkylestern, gegebenenfalls mit bis zu 40 Gew.-%, bezogen auf E.2 anderen polymerisierbaren, ethylenisch ungesättigten Monomeren sind. Zu den bevorzugten polymerisierbaren Acrylsäureestern gehören C₁-C₈-Alkylester, beispielsweise Methyl-, Ethyl-, Butyl-, n-Octyl- und 2-Ethylhexylester; Halogenalkylester, vorzugsweise Halogen-C₁-C₈-alkyl-ester, wie Chlorethylacrylat sowie Mischungen dieser Monomeren.

Zur Vernetzung können Monomere mit mehr als einer polymerisierbaren Doppelbindung copolymerisiert werden. Bevorzugte Beispiele für vernetzende Monomere sind Ester ungesättigter Monocarbonsäuren mit 3 bis 8 C-Atomen und ungesättigter einwertiger Alkohole mit 3 bis 12 C-Atomen, oder gesättigter Polyole mit 2 bis 4 OH-Gruppen und 2 bis 20 C-Atomen, wie z.B. Ethylenglykoldimethacrylat, Allylmethacrylat; mehrfach ungesättigte heterocyclische Verbindungen, wie z.B. Trivinyl- und Triallylcyanurat; polyfunktionelle Vinylverbindungen, wie Di- und Trivinylbenzole; aber auch Triallylphosphat und Diallylphthalat.

Bevorzugte vernetzende Monomere sind Allylmethacrylat, Ethylenglykoldimethacrylat, Diallylphthalat und heterocyclische Verbindungen, die mindestens 3 ethylenisch ungesättigte Gruppen aufweisen.

Besonders bevorzugte vernetzende Monomere sind die cyclischen Monomere Triallylcyanurat, Triallylisocyanurat, Triacryloylhexahydro-s-triazin, Triallylbenzole. Die Menge der vernetzten Monomere beträgt vorzugsweise 0,02 bis 5, insbesondere 0,05 bis 2 Gew.-%, bezogen auf die Pfropfgrundlage E.2.

Bei cyclischen vernetzenden Monomeren mit mindestens 3 ethylenisch ungesättigten Gruppen ist es vorteilhaft, die Menge auf unter 1 Gew.-% der Pfropfgrundlage E.2 zu beschränken.

Bevorzugte "andere" polymerisierbare, ethylenisch ungesättigte Monomere, die neben den Acrylsäureestern gegebenenfalls zur Herstellung der Pfropfgrundlage E.2 dienen können, sind beispielsweise Acrylnitril, Styrol, α-Methylstyrol, Acrylamide, Vinyl-C1-C6-alkylether, Methylmethacrylat, Butadien. Bevorzugte Acrylatkautschuke als Pfropfgrundlage E.2 sind Emulsionspolymerisate, die einen Gelgehalt von mindestens 60 Gew.-% aufweisen.

Weitere geeignete Pfropfgrundlagen gemäß E.2 sind Silikonkautschuke mit pfropfaktiven Stellen, wie sie in den DE-A 3 704 657 (= US 4 859 740), DE-A 3 704 655 (= US 4 861 831), DE-A 3 631 540 (= US 4 806 593) und DE-A 3 631 539 (= US 4 812 515) beschrieben werden.

Neben Elastomermodifikatoren, die auf Propfpolymeren beruhen, können ebenfalls nicht auf Propfpolymeren basierende Elastomermodifikatoren eingesetzt werden, die Glasübergangstemperaturen < 10°C, vorzugsweise < 0°C, besonders bevorzugt < -20°C aufweisen. Hierzu können z.B. Elastomere mit einer Block-Copolymerstruktur gehören. Hierzu können weiterhin z.B. thermoplastisch aufschmelzbare Elastomere gehören. Beispielhaft und bevorzugt sind hier EPM-, EPDM-und / oder SEBS-Kautschuke genannt.

Erfindungsgemäß können die thermoplastischen Formmassen in einer bevorzugten Ausführungsform neben dem teilkristallinen Thermoplasten und dem erfindungsgemäßen Stoffgemisch und zusätzlich zum Füllstoff und/oder Elastomermodifikator oder anstelle des Füllstoffs und/oder Elastomermodifikators noch Fließhilfsmittel zu 0,1 bis 20 Gew.-Teilen, vorzugsweise zu 0,25 bis 20 Gew.-Teilen, vorzugsweise zu 0,25 bis 15 Gew.-Teilen, besonders bevorzugt zu 1,0 bis 10 Gew.-Teilen enthalten.

Erfindungsgemäß bevorzugt einzusetzende Fließhilfsmittel bestehen aus Coplymerisaten, bevorzugt statistischen Copolymerisaten aus mindestens einem Olefin, bevorzugt α-Olefin und mindestens einem Methacrylsäureester oder Acrylsäureester eines aliphatischen Alkohols, wobei der MFI des Copolymerisats 100 g / 10 min, vorzugsweise 150 g / 10 min, besonders bevorzugt 300 g / 10 min nicht unterschreitet und dieser bei 190°C und einem Prüfgewicht von 2,16 kg gemessen bzw. bestimmt wird. In einer bevorzugten Ausführungsform besteht das Copolymerisat zu weniger als 4 Gew.-%, besonders bevorzugt zu weniger als 1,5 Gew.-% und ganz besonders bevorzugt zu 0 Gew.-% aus Monomerbausteinen, die weitere reaktive funktionelle Gruppen, ausgewählt aus der Gruppe umfassend Epoxide, Oxetane, Anhydride, Imide, Aziridine, Furane, Säuren, Amine, Oxazoline, enthalten.

Geeignete Olefine, bevorzugt α-Olefine, als Bestandteil der Copolymerisate weisen bevorzugt zwischen 2 und 10 Kohlenstoff-Atomen auf und können unsubstituiert oder mit einer oder mehreren aliphatischen, cycloaliphatischen oder aromatischen Gruppen substituiert sein.

Bevorzugte Olefine sind ausgewählt aus der Gruppe umfassend Ethen, Propen, 1-Buten, 1-Penten, 1-Hexen, 1-Octen, 3-Methyl-1-penten. Besonders bevorzugte Olefine sind Ethen und Propen, ganz besonders bevorzugt ist Ethen.

Ebenfalls geeignet sind Mischungen der beschriebenen Olefine.

In einer weiteren bevorzugten Ausführungsform werden die weiteren reaktiven funktionellen Gruppen, ausgewählt aus der Gruppe umfassend Epoxide, Oxetane, Anhydride, Imide, Aziridine, Furane, Säuren, Amine, Oxazoline, des Copolymerisates ausschließlich über die Olefine in das Copolymer eingebracht.

Der Gehalt des Olefins am Copolymerisat liegt zwischen 50 und 90 Gew.-%, bevorzugt zwischen 55 und 75 Gew.-%.

Das Copolymerisat wird weiterhin definiert durch den zweiten Bestandteil neben dem Olefin. Als zweiter Bestandteil sind Alkyl- oder Arylalkylester der Acrylsäure oder Methacrylsäure geeignet, deren Alkyl- oder Arylalkylgruppe aus 1-30 Kohlenstoffatomen gebildet wird. Die Alkyl- oder Arylalkylgruppe kann dabei linear oder verzweigt sein sowie cycloaliphatische oder aromatische Gruppen enthalten, daneben auch durch eine oder mehrere Ether- oder Thioetherfunktionen substituiert sein. Geeignete Methacrylsäure- oder Acrylsäureester in diesem Zusammenhang sind auch solche, die aus einer Alkoholkomponente synthetisiert wurden, die auf Oligoethylenglycol oder Oligopropylenglycol mit nur einer Hydroxylgruppe und maximal 30 C-Atomen basieren.

Bevorzugt kann die Alkyl- oder Arylalkylgruppe des Methacrylsäure- oder Acrylsäureesters ausgewählt sein aus der Gruppe umfassend Methyl, Ethyl, i-Propyl, n-Propyl, n-Butyl, i-Butyl, t-Butyl, 1-Pentyl, 1-Hexyl, 2-Hexyl, 3-Hexyl, 1-Heptyl, 3-Heptyl, 1-Octyl, 1-(2-Ethyl)-hexyl, 1-Nonyl, 1-Decyl, 1-Dodecyl, 1-Lauryl oder 1-Octadecyl. Besonders bevorzugt sind Alkyl- oder Arylalkylgruppen mit 5-20 Kohlenstoffatomen. Bevorzugt sind insbesondere auch verzweigte Alkylgruppen, die im Vergleich zu linearen Alkylgruppen gleicher Anzahl an Kohlenstoffatomen zu einer niedrigeren Glasübergangs-Temperatur TG führen.

Erfindungsgemäß besonders bevorzugt sind Copolymerisate, bei denen das Olefin mit Acrylsäure-(2-ethyl)-hexylester copolymerisiert wird. Ebenfalls geeignet sind Mischungen der beschriebenen Acrylsäure- oder Methacrylsäurester.

Bevorzugt ist hierbei die Verwendung von mehr als 60 Gew.-%, besonders bevorzugt mehr als 90 Gew.-% und ganz besonders bevorzugt die Verwendung von 100 Gew.-% Acrylsäure-(2-ethyl)-hexylester bezogen auf die Gesamtmenge an Acrylsäure- und Methacrylsäurester im Copolymerisat.

Der Gehalt der Acrylsäure- oder Methacrylsäureester am Copolymerisat liegt zwischen 10 und 50 Gew.-%, bevorzugt zwischen 25 und 45 Gew.-%.

Insbesondere Copolymerisate werden aus der Gruppe der von der Fa. Atofina unter dem Markennamen Lotryl® EH angebotenen Materialien, die gewöhnlich als Schmelzkleber Verwendung finden, ausgewählt.

In einer weiteren alternativen bevorzugten Ausführungsform können die erfindungsgemäßen thermoplastischen Formmassen auf Basis eines teilkristallinen Thermoplasten mit dem erfindungsgemäßen Stoffgemisch zusätzlich zu den oben genannten Komponenten oder anstelle der oben genannten Komponenten noch 0,001 bis 10 Gew.-Teile, bevorzugt 0,05 bis 5 Gew.-Teile, besonders bevorzugt 0,1 bis 3,5 Gew.-Teile eines anorganischen Pigmentes enthalten. Hierzu zählen neben den in Plastics Additives Handbook (5th Edition, Hans Zweifel (Ed.), Hanser Verlag München, S. 823-825) in Kapitel 15.2.5 genannten farbigen anorganischen Pigmenten bevorzugt auch die Weißpigmente Titandioxid, Zinksulfid und Zinkoxid sowie als schwarzes Pigment Ruß. Titandioxid kann in der kristallinen Form des Rutils und des Anatas eingesetzt werden, wobei Rutil bevorzugt ist. Das Titandioxid kann unbehandelt oder oberflächenbehandelt eingesetzt werden. Für die Oberflächenmodifizierung können Silicium- und/oder Aluminiumverbindungen sowie Siloxanverbindingen eingesetzt werden. Kommerziell erhältliche Produkte sind beispielsweise Kronos 2230, Kronos 2225 und Kronos vlp7000 der Fa. Kronos, Dallas, USA. Das Zinksulfid wird in der Regel als partikelförmiger Feststoff eingesetzt. Kommerziell erhältliche Produkte sind beispielsweise Sachtolith^{®} HDS oder Sachtolith^{®} HD (beide Fa. Sachtleben, Duisburg, Deutschland). Bevorzugt wird Titandioxid eingesetzt, wobei oberflächenmodifiziertes Titandioxid mit Silicium- und Aluminiumverbindungen sowie Siloxanen ganz besonders bevorzugt eingesetzt wird.

In einer weiteren alternativen bevorzugten Ausführungsform können die erfindungsgemäßen thermoplastischen Formmassen auf Basis eines teilkristallinen Thermoplasten mit dem erfindungsgemäßen Stoffgemisch zusätzlich zu den oben genannten Komponenten oder anstelle der oben genannten Komponenten noch 0,001 bis 10 Gew.-Teile, bevorzugt 0,05 bis 5 Gew.-Teile, besonders bevorzugt 0,1 bis 3,5 Gew.-Teile weitere übliche Additive enthalten.

Übliche Additive sind bevorzugt Stabilisatoren, besonders bevorzugt UV-Stabilisatoren, Thermostabilisatoren, Gammastrahlenstabilisatoren, Antistatika, Brandschutzadditive, Emulgatoren, Nukleierungsmittel, Weichmacher, weitere Farbmittel und Additive zur Erhöhung der elektrischen Leitfähigkeit. Die genannten und weitere geeignete Additive sind zum Beispiel beschrieben in Gächter, Müller, Kunststoff-Additive, 3. Ausgabe, Hanser-Verlag, München, Wien, 1989 und im Plastics Additives Handbook, 5th Edition, Hanser-Verlag, München, 2001. Die Additive können alleine oder in Mischung bzw. in Form von Masterbatchen eingesetzt werden.

Als Stabilisatoren werden bevorzugt phosphororganische Verbindungen, Phosphite, sterisch gehinderte Phenole, Hydrochinone, aromatische sekundäre Amine wie z.B. Diphenylamine, substituierte Resorcine, Salicylate, Benzotriazole und Benzophenone, sowie verschiedene substituierte Vertreter dieser Gruppen und deren Mischungen eingesetzt.

Als weitere Farbmittel werden bevorzugt Ruß und organische Pigmente wie zum Beispiel Phthalocyanine, Chinacridone, Perylene sowie Farbstoffe, insbesondere Nigrosin oder Anthrachinone zugesetzt.

Als Nukleierungsmittel werden bevorzugt Natrium- oder Calciumphenylphosphinat, Aluminiumoxid, Siliziumdioxid sowie bevorzugt Talkum eingesetzt.

Als Gleit- und Entformungsmittel werden bevorzugt Esterwachse, Pentaerytritoltetrastearat (PETS), langkettige Fettsäuren, besonders bevorzugt Stearinsäure oder Behensäure, deren Salze, besonders bevorzugt Ca- oder Zn-Stearat sowie Amidderivate, besonders bevorzugt Ethylen-bis-stearylamid oder Montanwachse (Mischungen aus geradkettigen, gesättigten Carbonsäuren mit Kettenlängen von 28 bis 32 C-Atomen) eingesetzt. Als Weichmacher werden bevorzugt Phthalsäuredioctylester, Phthalsäuredibenzylester, Phthalsäurebutylbenzylester, Kohlenwasserstofföle, N-(n-Butyl)benzolsulfonamid eingesetzt.

Als Additive können ebenfalls Polyolefine, bevorzugt Polyethylen und / oder Polypropylen eingesetzt werden. Besonders bevorzugt sind niedermolekulare Polyethylen- bzw. Polypropylenwachse.

Als Additive zur Erhöhung der elektrischen Leitfähigkeit werden bevorzugt Ruße, Leitfähigkeitsruße, Carbonfibrillen, nanoskalige Graphit- und Kohlenstofffasern, Graphit, leitfähige Polymere, Metallfasern sowie andere übliche Additive zur Erhöhung der elektrischen Leitfähigkeit zugesetzt. Als nanoskalige Fasern werden bevorzugt sogenannte "single wall Kohlenstoff-Nanotubes" oder "multi wall Kohlenstoff-Nanotubes" (z.B. der Firma Hyperion Catalysis) eingesetzt werden.

Als Brandschutzadditiv können die erfindungsgemäßen glühdrahtbeständigen Polyesterformmassen zusätzliche handelsübliche organische Halogenverbindungen mit Synergisten oder handelsüblichen organischen Stickstoffverbindungen oder organisch/anorganische Phosphorverbindungen einzeln oder im Gemisch eingesetzt werden. Auch mineralische Flammschutzadditive wie Magnesiumhydroxid oder Ca-Mg-Carbonat-Hydrate (z.B. DE-A 4 236 122 (= CA 2 109 024 A1)) können eingesetzt werden. Ebenso kommen Salze aliphatischer oder aromatischer Sulfonsäuren in Frage. Als Chlor-haltige Brandschutzadditive seien bevorzugt Tetrachlorbisphenol-A-oligocarbonat genannt. Als organische Phosphorverbindungen sind bevorzugt die Phosphorverbindungen gemäß WO-A 98/17720 (= US 6 538 024) geeignet, insbesondere Triphenylphosphat (TPP), Resorcinol-bis(diphenylphosphat) (RDP) und die daraus abgeleiteten Oligomere sowie Bisphenol-A-bisdiphenylphosphat (BDP) und die daraus abgeleiteten Oligomere, organische und anorganische Phosphonsäurederivate und deren Salze, organische und anorganische Phosphinsäurederivate und deren Salze, insbesondere Metalldialkylphosphinate wie Aluminium-tris[dialkylphosphinate] oder Zink-bis[dialkylphosphinate], außerdem roter Phosphor, Phosphite, Hypophosphsite, Phospinoxide, Phosphazene, Melaminpyrophosphat und deren Mischungen. Als Stickstoffverbindungen werden als Brandschutzadditive bevorzugt solche aus der Gruppe der Allantoin-, Cyanursäure-, Dicyandiamid, Glycouril-, Guanidin-, Ammonium- und Melaminderivate, besonders bevorzugt Allantoin, Benzoguanamin, Glykouril, Melamin, Kondensationsprodukte des Melamins, z.B. Melem, Melam oder Melom bzw. höher kondensierte Verbindungen dieses Typs und Addukte des Melamins mit Säuren wie z.B. mit Cyanursäure (Melamincyanurat), Phosphorsäure (Melaminphosphat) oder kondensierten Phosphonsäuren (z.B. Melaminpolyphosphat) eingesetzt. Als Synergisten werden bevorzugt Zinkverbindungen, bevorzugt Zinkborat, Zinkoxid, Zinkphosphat und Zinksulfid, Zinnverbindungen, bevorzugt Zinnstannat und Zinnborat sowie Magnesiumverbindungen, bevorzugt Magesiumoxid, Magnesiumcarbonat und Magnesiumborat eingesetzt. Auch können dem Flammschutzmittel sogenannte Kohlenstoffbildner, bevorzugt Phenol-Formaldehydharze, Polycarbonate, Polyphenylether, Polyimide, Polysulfone, Polyethersulfone, Polyphenylosulfide und Polyetherketone sowie Antitropfmittel wie Tetrafluorethylenpolymerisate zugesetzt werden.

Die Herstellung der erfindungsgemäßen, glühdrahtbeständigen Polysterformmassen erfolgt nach bekannten Verfahren durch Mischen der Komponenten. Das Mischen der Komponenten erfolgt durch Vermischen der Komponenten in den entsprechenden Gewichtsanteilen. Vorzugsweise geschieht das Mischen der Komponenten bei Temperaturen von 220 bis 330°C durch gemeinsames Vermengen, Vermischen, Kneten, Extrudieren oder Verwalzen der Komponenten. Es kann vorteilhaft sein, einzelne Komponenten vorzumischen. Es kann weiterhin vorteilhaft sein, Formteile oder Halbzeuge aus einer bei Raumtemperatur (bevorzugt 0 bis 40°C) hergestellten physikalischen Mischung (Dryblend) vorgemischter Komponenten und/oder einzelner Komponenten direkt herzustellen.

Die vorliegende Erfindung betrifft ferner die Verwendung der erfindungsgemäßen glühdrahtbeständigen Polyesterformmassen zur Herstellung von Formteilen, bevorzugt Formteilen mit metallisierbaren Oberflächen durch Laser-Direkt-Strukturieren (LDS-Verfahren).

Die Anwendung des LDS-Verfahrens zur Herstellung spritzgegossener Schaltungsträger ist aus Kunststoffe, Jahrgang 92, (2002) 11, Seiten 3 bis 7, Carl Hanser Verlag, München sowie aus DE 19731346A1, WO 00/35259A2, DE 19723734A1 bekannt.

Beim LDS-Verfahren wird die additive Metallisierung zur Herstellung einer metallischen Leiterbahnstruktur auf einem nicht strukturleitenden Trägersubstanz realisiert; die Besonderheit des Verfahrens liegt im Erzeugen der Bekeimung. Die erforderlichen Keime werden in chemisch passiviertem Zustand feinstverteilt in den thermoplastischen Kunststoff eingebracht; sie können nach dem Spritzgießen mit geeigneter Laserstrahlung in den Leiterbahnbereichen der Bauteiloberfläche freigesetzt werden. Nach einer chemisch reduktiven Metallisierung ist dann ein spritzgegossener Schaltungsträger fertig.

Als spritzgegossene Schaltungsträger, auch Molded Interconnect Devices (MID) genannt, bezeichnet man also elektronische Bauteile, bei denen metallische Leiterbahnen auf spritzgegossene Kunststoffträger aufgetragen werden. Die spritzgegossenen Schaltungsträger können beispielsweise in der Industrieelektronik, der Telekommunikationselektronik, der Automobilelektronik, im Transportwesen, in der Medizintechnik, in der Unterhaltungstechnik oder in der Mess- und Steuertechnik eingesetzt werden. Die Vorteile von spritzgegossenen Schaltungsträgern liegen insbesondere im Vergleich zur Leiterplattentechnik in der hohen Designfreiheit und der Möglichkeit der Funktionsintegration. Dadurch wird eine Kombination von elektrischen und mechanischen Eigenschaften ermöglicht. Weiterhin ist es durch diese Kombination möglich, die Anzahl von Bauteilen in der fertigen Anwendung zu reduzieren und damit den Herstellungsprozess effektiver zu machen.

Die Herstellung spritzgegossener, dreidimensionaler Schaltungsträger mittels additiver Metallisierung wird beispielsweise in EP 1 274 288 A1 oder WO 03/005784 A2 beschrieben.

Die vorliegende Erfindung betrifft deshalb auch spritzgegossene, dreidimensionale Schaltungsträger erhältlich durch Spritzgießen der glühdrahtbeständigen Polyesterformmassen gemäß der Beschreibung mit anschließender Laser-Direkt-Strukturierung.

Die vorliegende Erfindung betrifft bevorzugt die Verwendung der erfindungsgemäßen glühdrahtbeständigen Polyesterformmassen zur Herstellung spritzgegossener dreidimensionaler Schaltungsträger, bevorzugt zur Herstellung von Kippschaltern, Drehschaltern, Reglern, Verbindungselementen, Steckverbindern, Gehäusen, Kontaktkammern, Relais, Widerständen, Kondensatoren, Schütze, induktiven Bauelementen, Transformatoren, Transistoren oder Sensoren mit elektrischen Leiterbahnen mach dem LDS-Verfahrens.

Schließlich betrifft die vorliegende Erfindung die Verwendung der erfindungsgemäß erhältlichen spritzgegossenen Schaltungsträger in der Industrieelektronik, der Telekommunikationselektronik, der Automobilelektronik, im Transportwesen, in der Medizintechnik, in der Unterhaltungselektronik oder in der Mess- und Steuertechnik.

### Beispiele

### Untersuchte Parameter:

### Brandprüfungen:

Glow Wire Flammability Index (GWFI) nach IEC/EN 60695-2-12

Glow Wire Ignition Tempeature (GWIT) nach IEC/EN 60695-2-13

V-Klassifizierung nach UL94

### Ermittlung der Haftfestigkeit von im LDS-Verfahren hergestellten Leiterbahnen

Aus den für das LDS-Verfahren entwickelten Formmassen werden im üblichen Spritzgussprozess Prüfplatten hergestellt. Anschließend wird mit einem NdYag-Laser (Laserwellenlänge: 1064 nm) das erforderliche Layout (Leiterbahnstruktur) auf dem Formteil eingebrannt. Bei diesem Prozess werden die in der Formmasse enthaltenen Additive für die anschließende Verkupferung aktiviert.

Die notwendigen Laserparameter hängen von der Formmasse und der Oberflächenbeschaffenheit ab. Typische Werte sind:
- Laserleistung: 3 - 5 W
- Geschwindigkeit: 2000 mm/s
- Pulswiederholfrequenz: 40 - 100 kHz

Nach einem notwendigen Reinigungsschritt zur Entfernung der durch die Laserstrukturierung entstandenen Ablationen erfolgt der additive Leiterbahnaufbau mit Hilfe von stromlosen Cu-Bädern (z. B. von der Firma Rohm and Haas). Nach einem Schichtaufbau von ca. 10 µm erfolgt eine galvanischc Erhöhung der Schichtdicke auf 30 - 35 µm. Diese Schichtdicke ist für die folgende Prüfung erforderlich.

Die Haftungsmessung erfolgte bei der Firma LPKF Laser & Electronics AG, Osteriede 7, D-30827 Garbsen.

### Zusammensetzung der Formmassen:

- Komponente A1:: Lineares Polybutylenterephthalat (Pocan^{®} B 1300, Handelsprodukt der Lanxess Deutschland GmbH, Leverkusen, Deutschland) mit einer Intrinsischen intrinsischen Viskosität von ca. 0,93 cm³/g (gemessen in Phenol : 1,2-Dichlorbenzol = 1:1 bei 25°C)
- Komponente A2:: Lineares Polyethylenterephthalat (PET V004, Fa. Invista, Wichita, USA)
- Komponente B:: Kupferchromit (CuCr₂O₄) CAS-Nr. 12018-10-9 (Pigmentschwarz PK3095 der Fa. FERRO GmbH, Cleveland, USA
- Komponente C1:: Antimontrioxid-Masterbatch in PBT (80/20) (Campine PBT 261530, Fa. Campine, Beerse, Belgien)
- Komponente C2:: Natriumantimonat CAS-Nr. 15432-85-6 (Thermogard FR, Fa. Chemtura, Manchester, UK)
- Komponente D1:: Tetrabrombisphenol-A-epoxyoligomer(F-3100, Fa. ICL IP, Beer Sheva, Israel)
- Komponente D2:: Tetrabrombisphenol-A-oligocarbonat (BC52, Fa. Chemtura, Middlebury, USA)
- Komponente D3:: Poly(pentabrombenzylacrylat (FR-1025, Fa. ICL IP, Beer Sheva, Israel)
- Komponente D4:: N,N'-Ethylenbis(tetrabromphthalimid (Saytex BT93, Fa. Albemarle, Baton Rouge, USA)
- Komponente E1:: Kautschuk auf Basis eines Methacrylat / Butadien / Styrol-Polymers (Paraloid EXL2650, Rohm und Haas, Philadelphia, USA)
- Komponente E2:: Kautschuk auf Basis eines Acrylnitril-Butadien-Sytrol-Copolymerisates (Novodur P60 der Fa. Ineos, Hampshire,UK)
- Komponente F:: Füllstoffe und Verstärkungsstoffe wie Talkum (Jetfine 3CA, Fa. RioTintoMinerals, London, UK) oder Glasfasern (CS 7967, Handelsprodukt der Lanxess N.V., Antwerpen, Belgien)
- Komponente G:: weitere für die Verwendung in Polyestern gebräuchliche anorganische Pigmente wie Titandioxid (Kronos 2230 der Fa. Kronos, Dallas, USA) oder (Sachtolith^{®}HDS der Fa. Sachtleben, Duisburg, Deutschland)
- Komponente H:: weitere für die Verwendung in Polyestern gebräuchliche Additive wie Ent- former, Thermostabilisatoren und Nukleierungsmittel, Tropfschutzmittel.

Die verwendeten weiteren Additive (Komponente G und H) stimmen für entsprechende Vergleichsbeispiele und Beispiele jeweils in Art und Menge überein.

### Eigenschaften der Formmassen:

| **Komponente** | | **1** | **2** | **3** | **4** | **5** | **V1** | **V2** | **V3** | **V4** |
|---|---|---|---|---|---|---|---|---|---|---|
| A1 | | 44,9 | 45,9 | 46,9 | 11,9 | | 60.1 | 49,4 | 49,8 | 45,9 |
| A2 | | | | | 30 | 43, 9 | | | | |
| D1 | | 11 | | | | | | 11 | | |
| D2 | | | 10 | | | | | | 10 | 10 |
| D3 | | | | 9 | | | | | | |
| D4 | | | | | 10 | 8 | | | | |
| C1 | | | | | 4 | 4 | | | | |
| C2 | | 4,5 | 4,5 | 4,5 | | | | | 5,6 | 5,6 |
| B | | 5 | 5 | 5 | 3,5 | 3,5 | 5 | 5 | | |
| E1 | | 5 | 5 | 5 | | | 5 | 5 | 0 | 5 |
| E2 | | | | | 5 | 5 | | | | |
| F | | 25 | 25 | 25 | 35 | 35 | 25 | 25 | 30 | 30 |
| G | | 4 | 4 | 4 | | | 4 | 4 | 4 | 4 |
| H | | 0,6 | 0,6 | 0,6 | 0,6 | 0,6 | 0,6 | 0,6 | 0,6 | 0,6 |
| GWIT (0,75 mm) (IEC60695-2-13) | [°C] | 850 | 775 | 775 | 875 | 850 | <750 | <750 | <750 | <750 |
| UL94 (1,5 mm) | Klasse | V-0 | V-0 | V-0 | V-0 | V-0 | HB | HB | V-0 | V0 |
| GWFI (0,75 mm) (IEC60695-2-12) | [°C] | 960 | 960 | 960 | 960 | 960 | <750 | <960 | 960 | 960 |
| Laserinduzierte 3D-MID Metallisierbarkeit | Intern | ++ | ++ | ++ | ++ | ++ | ++ | ++ | -- | -- |

Aus der Tabelle ist klar ersichtlich, dass nur die erfindungsgemäßen Formmassen zusätzlich zu V0-Klassifizierung und einem GWFI von 960°C auch einen GWIT ≥ 775°C und eine sehr gute laserinduzierte 3D-MID Metallisierbarkeit zeigen.

## Patentansprüche

1. Glühdrahtbeständige Polyesterformmassen enthaltend Kupferchromit (CuCr₂O₄) und wenigstens ein Antimon-haltiges Funktionsadditiv der Reihe Natriumantimonat, Antimontrioxid oder Antimonpentoxid in Kombination mit wenigstens einer organischen Bromverbindung der Reihe N,N-Ethylenbis(tetrabromphthalimid), epoxidiertes Tetrabrombisphenol A-Harz, Tetrabrombisphenol-A-oligocarbonat, Pentabrompolyacrylat, Polypentabrombenzylacrylat, bromiertes Polystyrol, Decabromdiphenylether oder Decabromdiphenylethan.

2. Glühdrahtbeständige Polyesterformmassen gemäß Anspruch 1 enthaltend Kupferchromit, Antimontrioxid sowie eine organische Bromverbindung der Reihe Tetrabrombisphenol-A-epoxyoligomer, Tetrabrombisphenol-A-oligocarbonat, Polypentabrombenzylacrylat oder N-N'-Ethylen-bis(tetrabromphthalimid).

3. Glühdrahtbeständige Polyesterformmassen gemäß Anspruch 1 enthaltend Kupferchromit, Natriumantimonat sowie eine organische Bromverbindung der Reihe Tetrabrombisphenol-A-epoxyoligomer, Tetrabrombisphenol-A-oligocarbonat, Polypentabrombenzylacrylat oder N-N'-Ethylen-bis(tetrabromphthalimid).

4. Glühdrahtbeständige Polyesterformmassen gemäß Anspruch 1, **dadurch gekennzeichnet, dass** sie als Komponente A 40 bis 90 Gew.-% Polyester, als Komponente B 0,1 bis 40 Gew.-% Kupferchromit, als Komponente C 0,1 bis 15 Gew.-% Antimon-haltiges Funktionsadditiv und als Komponente D 0,1 bis 20 Gew.-% organische Bromverbindung enthalten.

5. Glühdrahtbeständige Polyesterformmassen gemäß der Anspruch 4, **dadurch gekennzeichnet, dass** sie die Komponente A in Mengen von 45 bis 65 Gew.-% enthalten.

6. Glühdrahtbeständige Polyesterformmassen gemäß der Ansprüche 4 bis 5, **dadurch gekennzeichnet, dass** sie die Komponente B in Mengen von 0,5 bis 20 Gew.-% enthalten.

7. Glühdrahtbeständige Polyesterformmassen gemäß der Ansprüche 4 bis. 6, **dadurch gekennzeichnet, dass** sie die Komponente C in Mengen von 0,5 bis 10 Gew.-% enthalten.

8. Glühdrahtbeständige Polyesterformmassen gemäß der Ansprüche 4 bis 7, **dadurch gekennzeichnet, dass** sie die Komponente D in Mengen von 0,5 bis 18 Gew.-% enthalten.

9. Verwendung der glühdrahtbeständigen Polyesterformmassen gemäß einem der Ansprüche 1 bis 8 zur Herstellung von Formteilen, bevorzugt von Formteilen mit metallischen Oberflächen durch Laser-Direkt-Strukturieren.

10. Verwendung der glühdrahtbeständigen Polyesterformmassen gemäß einem der Ansprüche 1 bis 8, bevorzugt der daraus erhältlichen Formteile mit metallischen Oberflächen, zur Herstellung spritzgegossener Schaltungsträger, bevorzugt Kippschalter, Drehschalter, Regler, Verbindungselemente, Steckverbinder, Gehäuse, Kontaktkammern, Relais, Widerstände, Kondensatoren, Schütze.

11. Spritzgegossene dreidimensionale Schaltungsträger erhältlich durch Spritzgießen der glühdrahtbeständigen Polyesterformmassen gemäß einem der Ansprüche 1 bis 8 mit anschließender Laser-Direkt-Strukturierung.

12. Verwendung spritzgegossener Schaltungsträger nach Anspruch 11 in der Industrieelektronik, der Telekommunikationselektronik, der Automobilelektronik, im Transportwesen, in der Medizintechnik, in der Unterhaltungselektronik oder in der Mess- und Steuertechnik.

## Claims

1. Glow-wire-resistant polyester moulding compositions comprising copper chromite (CuCr₂O₄) and at least one antimony-containing functional additive from the group of sodium antimonate, antimony trioxide or antimony pentoxide, in combination with at least one organic bromine compound from the group of N,N-ethylenebis(tetrabromophthalimide), epoxidized tetrabromobisphenol A resin, tetrabromobisphenol A oligocarbonate, pentabromopolyacrylate, polypentabromobenzyl acrylate, brominated polystyrene, decabromodiphenyl ether or decabromodiphenylethane.

2. Glow-wire-resistant polyester moulding compositions according to Claim 1 comprising copper chromite, antimony trioxide, and also an organic bromine compound from the group of tetrabromobisphenol A epoxyoligomer, tetrabromobisphenol A oligocarbonate, polypentabromobenzyl acrylate or N,N'-ethylenebis(tetrabromophthalimide).

3. Glow-wire-resistant polyester moulding compositions according to Claim 1 comprising copper chromite, sodium antimonate, and also an organic bromine compound from the group of tetrabromobisphenol A epoxyoligomer, tetrabromobisphenol A oligocarbonate, polypentabromobenzyl acrylate or N,N'-ethylenebis(tetrabromophthalimide).

4. Glow-wire-resistant polyester moulding compositions according to Claim 1, **characterized in that** they comprise from 40 to 90% by weight of polyester as component A, from 0.1 to 40% by weight of copper chromite as component B, from 0.1 to 15% by weight of antimony-containing functional additive as component C and from 0.1 to 20% by weight of organic bromine compound as component D.

5. Glow-wire-resistant polyester moulding compositions according to Claim 4, **characterized in that** they comprise amounts of from 45 to 65% by weight of component A.

6. Glow-wire-resistant polyester moulding compositions according to Claims 4 and 5, **characterized in that** they comprise amounts of from 0.5 to 20% by weight of component B.

7. Glow-wire-resistant polyester moulding compositions according to Claims 4 to 6, **characterized in that** they comprise amounts of from 0.5 to 10% by weight of component C.

8. Glow-wire-resistant polyester moulding compositions according to Claims 4 to 7, **characterized in that** they comprise amounts of from 0.5 to 18% by weight of component D.

9. Use of the glow-wire-resistant polyester moulding compositions according to any of Claims 1 to 8 for the production of mouldings, preferably of mouldings with metallic surfaces, via laser direct structuring.

10. Use of the glow-wire-resistant polyester moulding compositions according to any of Claims 1 to 8, preferably of the mouldings obtainable therefrom with metallic surfaces, for the production of injection-moulded circuit substrates, preferably toggle switches, rotary switches, regulators, connecting elements, plug connectors, casings, contact chambers, relays, resistors, capacitors, contactors.

11. Three-dimensional injection-moulded circuit substrates obtainable via injection moulding of the glow-wire-resistant polyester moulding compositions according to any of Claims 1 to 8, with subsequent laser direct structuring.

12. Use of injection-moulded circuit substrates according to Claim 11 in industrial electronics, in telecommunications electronics, in automotive electronics, in the field of transport, in medical technology, in entertainment electronics or in measurement-and-control technology.

## Revendications

1. Matériaux de moulage en polyester résistants au test du fil incandescent contenant du chromite de cuivre (CuCr₂O₄) et au moins un additif fonctionnel contenant de l'antimoine de la série de l'antimoniate de sodium, du trioxyde d'antimoine ou du pentoxyde d'antimoine en combinaison avec au moins un composé de brome organique de la série du N,N-éthylène-bis(tétrabromophtalimide), de la résine de tétrabromobisphénol A époxydée, de l'oligocarbonate de tétrabromobisphénol A, du pentabromopolyacrylate, du polyacrylate de pentabromobenzyle, du polystyrène bromé, de l'éther de décabromodiphényle ou du décabromodiphényléthane.

2. Matériaux de moulage en polyester résistants au test du fil incandescent selon la revendication 1, contenant du chromite de cuivre, du trioxyde d'antimoine et un composé de brome organique de la série de l'époxyoligomère de tétrabromobisphénol A, de l'oligocarbonate de tétrabromobisphénol A, du polyacrylate de pentabromobenzyle ou du N,N'-éthylène-bis(tétrabromophtalimide).

3. Matériaux de moulage en polyester résistants au test du fil incandescent selon la revendication 1, contenant du chromite de cuivre, de l'antimoniate de sodium et un composé de brome organique de la série de l'époxyoligomère de tétrabromobisphénol A, de l'oligocarbonate de tétrabromobisphénol A, du polyacrylate de pentabromobenzyle ou du N,N'-éthylène-bis(tétrabromophtalimide).

4. Matériaux de moulage en polyester résistants au test du fil incandescent selon la revendication 1, **caractérisés en ce qu'**ils contiennent en tant que composant A 40 à 90 % en poids de polyester, en tant que composant B 0,1 à 40 % en poids de chromite de cuivre, en tant que composant C 0,1 à 15 % en poids d'un additif fonctionnel contenant de l'antimoine et en tant que composant D 0,1 à 20 % en poids d'un composé de brome organique.

5. Matériaux de moulage en polyester résistants au test du fil incandescent selon la revendication 4, **caractérisés en ce qu'**ils contiennent le composant A en quantités de 45 à 65 % en poids.

6. Matériaux de moulage en polyester résistants au test du fil incandescent selon les revendications 4 à 5, **caractérisés en ce qu'**ils contiennent le composant B en quantités de 0,5 à 20 % en poids.

7. Matériaux de moulage en polyester résistants au test du fil incandescent selon les revendications 4 à 6, **caractérisés en ce qu'**ils contiennent le composant C en quantités de 0,5 à 10 % en poids.

8. Matériaux de moulage en polyester résistants au test du fil incandescent selon les revendications 4 à 7, **caractérisés en ce qu'**ils contiennent le composant D en quantités de 0,5 à 18 % en poids.

9. Utilisation des matériaux de moulage en polyester résistants au test du fil incandescent selon l'une quelconque des revendications 1 à 8 pour la fabrication de pièces moulées, de préférence de pièces moulées à surfaces métalliques par structuration directe par laser.

10. Utilisation des matériaux de moulage en polyester résistants au test du fil incandescent selon l'une quelconque des revendications 1 à 8, de préférence des pièces moulées à surfaces métalliques pouvant être obtenues à partir de ceux-ci, pour la fabrication de supports d'interconnexion moulés par injection, de préférence d'interrupteurs à bascule, d'interrupteurs rotatifs, de régulateurs, d'éléments de connexion, de connecteurs, de boîtiers, de chambres de contact, de relais, de résistances, de condensateurs, de contacteurs.

11. Supports d'interconnexion tridimensionnels moulés par injection pouvant être obtenus par moulage par injection des matériaux de moulage en polyester résistants au test du fil incandescent selon l'une quelconque des revendications 1 à 8, avec structuration directe par laser ultérieure.

12. Utilisation de supports d'interconnexion moulés par injection selon la revendication 11 dans l'électronique industrielle, dans l'électronique des télécommunications, dans l'électronique automobile, dans les transports, dans la technologie médicale, dans l'électronique des divertissements ou dans la technologie de la mesure et de la commande.
